# EUROPEAN PATENT SPECIFICATION

(11) **EP 1 410 871 B1**
(45) Date of publication and mention of the grant of the patent: **26.03.2008**
(21) Application number: 03292592.7
(22) Date of filing: 17.10.2003
(51) Int. Cl.: B23K 35/26, C22C 13/00

(54) **Lead-free solder ball**
Bleifreie Lötkugel
Bille de soudure sans plomb

(30) Priority: 17.10.2002 JP 2002303197
(43) Date of publication of application: 21.04.2004
(73) Proprietor: SENJU METAL INDUSTRY CO., LTD., Tokyo, 120-8555 (JP)
(72) Inventor: Katoh, Rikiya, Souka-shi Saitama (JP); Nomoto, Shinichi, Hanyu-shi Saitama (JP); Okada, Hiroshi, Mouka-shi Tochigi (JP)
(74) Representative: Ahner, Francis

(56) References cited:
- EP-A- 1 148 548
- EP-A- 1 213 089
- US-A- 5 445 666
- US-A- 5 653 783
- US-A- 5 817 194
- US-A1- 2002 051 728
- US-B1- 6 231 691

## Description

### Technical Field

The present invention relates to a lead-free solder ball suitable for use in soldering of electronic components.

### Background Art

Nowadays, as electronic products are required to be multifunctional and have a reduced size, electronic components, which form the core of electronic products, are also required to be multifunctional and have a reduced size.

In conventional electronic components, a semiconductor chip is mounted on a lead frame made of a metal such as copper or Alloy 42 (42 Ni-Fe alloy), and the chip is electrically connected to the lead frame by wire bonding with gold wires before being sealed with ceramic or plastic. However, with such an electronic component using a lead frame, there is a limit on the extent to which the size of the electronic component can be reduced since the lead frame occupies its own space on a printed circuit board. The use of a lead frame also puts a limit on the speed of operation, since the lead frame increases the length of electrical connections on which the speed of operation depends.

In view of these problems of electronic components using a lead frame, another type of electronic component called a BGA (ball grid array) package was developed. A BGA package employs solder bumps formed from solder balls in order to connect and secure the package to a printed circuit board. Therefore, the length of electrical connection is shorter than for electronic components using lead frames, thereby making it possible to increase the speed of operation. The space occupied by a lead frame is no longer necessary, so a BGA package also makes it possible to save space. Recently, more compact BGA packages called FBGA (fine ball grid array) packages or CSP's (chip size packages) having nearly the same size as the chips packaged therein and having a finer electrode pitch have been produced. BGA packages, including CSP's, are now widely used, and solder ball-mounting technology is becoming prevalent in the mounting of electronic components.

A BGA package has a substrate on which a semiconductor chip is mounted. The substrate has solder bumps on its back surface which are formed from solder balls arranged in a grid-like array. In a typical method for forming the solder bumps, a solder ball feeder equipped with a suction plate is used. The suction plate has holes arranged in the same grid-like array as the solder bumps to be formed. Solder balls are positioned on a substrate by pulling a solder ball into each hole of the feeder by suction applied through the holes, and after positioning the feeder above a substrate, releasing the suction to place or mount each ball onto the substrate. The solder balls are temporarily kept in position on the substrate by the stickiness of a soldering flux, which has previously been applied to the surface of the substrate on which solder bumps are to be formed. The substrate having the solder balls mounted thereon is then heated in a reflow furnace to melt the solder balls and form them into solder bumps secured to the substrate. The substrate having solder bumps thus formed is normally inspected by an optical inspection machine in order to check if all the solder bumps required to make the desired grid-like array are properly formed.

Solder balls which are used in the production of BGA packages, including CSP's, have a spherical shape with a diameter in the range of 0.05 - 2.0 mm. It is desired for solder balls to have good sphericity and a smooth surface. If the sphericity of a solder ball is not good or if its surface has significant surface irregularities or defects such as shrinkage cavities or wrinkles, problems may occur during placement of the solder ball on a substrate, such as caused by failure of the feeder to pick up the solder ball due to a loss of suction or a failure of the feeder to release the solder ball due to biting of the ball into one of the holes in the feeder.

It is also desired for solder balls to form solder bumps having a smooth surface with a uniform gloss when heated in a reflow furnace. The optical inspection of solder bumps formed on a substrate is conducted by focusing normally on solder bumps having a glossy surface or in some cases on solder balls having a non-glossy surface, so the formation of solder bumps, some of which have a glossy surface and others of which have a non-glossy surface, makes it difficult to adjust the focus in the optical inspection of the solder bumps and results in a failure to identify some of the bumps.

The solder that has been used most widely in soldering is an Sn-Pb alloy. Sn-Pb solder has been used since ancient times and has the advantages of a low melting point and good solderability. In addition, an Sn-Pb alloy having an Sn content of 63 wt% or 75 at%, which is a representative composition for an Sn-Pb solder, has the excellent properties that it forms a soldered joint having a smooth surface with good gloss.

Solder balls made of an Sn-Pb alloy have a smooth surface, so they can be smoothly mounted onto a substrate by use of the above-described solder ball feeder. In addition, after heating in a reflow furnace, they form solder bumps having a smooth and glossy surface which does not interfere with optical inspection of the solder bumps.

Recently, the use of an Sn-Pb solder has been disfavored due to the toxic nature of Pb. When waste electronic product such as computers are disposed of, they are normally disassembled to remove plastic and metallic parts for recycling. Printed circuit boards on which electronic components are mounted are not adapted for recycling since plastic and metallic portions are combined therein, so the printed circuit boards are removed from waste electronic products, shredded, and buried in the ground. When rain which has been acidified due to air pollution contacts shredded printed circuit boards buried in the ground, the lead (Pb) in the Sn-Pb solder may be dissolved out and contaminate underground water. If a human or animal continues to drink lead-containing water for many years, there is the possibility of lead accumulating in its body and causing lead poisoning.

Accordingly, it is now highly recommended, from an environmental standpoint, to use a "lead-free" solder, which is completely free from lead, in soldering of electronic components.

Lead-free solders which are considered promising at present are Sn-Ag solders and particularly Sn-Ag-Cu solders in view of their ease of handling. Documents EP-A-1 213 089 and US-B-6 231 691 disclose examples of such Sn-Ag-Cu solders. However, the wettability of these lead-free solders is generally lower than that of Sn-Pb solders. For example, in a spreading test, an Sn-Ag-Cu lead-free solder shows a spreading factor of approximately 80% that of an Sn-Pb solder.

When solder balls are made from such an Sn-Ag-Cu lead-free solder, the surfaces of the resulting solder balls have shrinkage cavities and wrinkles, thereby increasing the occurrence of the above-described problems during mounting of solder balls on a substrate using the above-described solder ball feeder. In addition, after the solder balls are heated in a reflow furnace to form solder bumps, the surfaces of the resulting solder bumps tend to be glossy for some bumps and non-glossy for other bumps. The formation of glossy bumps interspersed with non-glossy bumps makes optical inspection of the solder bumps difficult and increases the rate of misidentification. These disadvantages have been an impediment to the use of lead-free solders as a material for solder balls in place of conventional Sn-Pb solders.

### Disclosure of the Invention

The present invention provides a solder ball of an Sn-Cu-Ag-based, lead-free solder which has a smooth surface having little or no shrinkage cavities or wrinkles.

More particularly, in one aspect, the present invention provides a solder ball as defined in claim 1.

In another aspect, the present invention also provides a substrate for a ball grid array package (including CSP) as defined in claim 3.

The present invention also relates to a method of forming solder bumps as defined in claim 2.

### Brief Description of the Drawings

Figure 1 is an electron photomicrograph of solder balls of an Sn-Cu-Ag-Co lead-free solder according to the present invention.
Figure 2 is an electron photomicrograph of solder balls of an Sn-Cu-Ag lead-free solder.
Figure 3 is an electron photomicrograph of solder balls of a conventional Sn-Pb solder.

### Detailed Description of the Invention

Spherical solder balls can be produced either by remelting solid masses of solder of a certain size followed by cooling, or by forming droplets of a certain size from molten solder followed by cooling. In either method, molten solder of a certain size is cooled and changed into a solid. In the course of solidification, some of the elements of the solder initially crystallize out in the liquid mass, and the resulting crystals, which serve as nuclei for crystal growth, gradually grow until the entire mass becomes solid. This crystal growth may sometimes occur unidirectionally, i.e., in a certain direction, thereby forming dendrites.

When molten solder is cooled so as to solidify, a conventional Sn-Pb solder, and particularly a eutectic Sn-Pb solder finishes solidifying in a short time. In contrast, an Sn-Cu-Ag solder takes a longer time to finish solidifying, as suggested by its DSC (differential scanning calorimetry) curve in which the solidifying peak is wider than that of an Sn-Pb solder. In addition, because of the actual cooling speed during solidification which is not slow enough to result in equilibrium, the alloy composition at the final solidification stage deviates from the eutectic composition. With an Sn-Cu-Ag solder, this deviation becomes greater than with an Sn-Pb solder, and the degree of supercooling is also greater. As a result, during transition from a liquid to a solid phase, solid solution tends to form excessively, thereby causing the formation of dendrites or coarse crystals, which when grown, lead to the formation of surface detects such as shrinkage cavities and wrinkles and significant surface irregularities.

During solidification of molten solder, if a large number of nuclei which initially crystallize out are present in the molten solder, it becomes difficult to form a solid solution excessively, which in turn makes it difficult to form dendrites or coarse crystals.

According to the present invention, Co is added to an Sn-Cu-Ag solder in an amount of 0.01 - 2 atomic percent (at%). Each of these elements has a melting point which is much higher than those of Sn, Cu, and Ag. Therefore, during solidification of molten solder, these elements initially crystallize out to form a large number of nuclei for crystal growth. It has been found that addition of Co is effective for producing solder balls having a smooth surface in which the formation of shrinkage cavities and wrinkles is prevented, thereby making it possible to produce solder balls which can be smoothly mounted on a substrate using a solder ball feeder of the above-described type. The solder balls can form solder bumps having a uniform glossy surface, which facilitates optical inspection and minimizes the occurrence of misidentification.

These effects are not appreciable if the Co content is less than 0.01 at%. If this content is more than 2 at%, the Co become segregating on the surface of the solder balls without dissolving into the inside thereof, thereby deteriorating the wettability of the solder balls when melted and adversely affecting the surface smoothness and gloss thereof. The Co content is preferably in the range of 0.02 - 0.5 at%.

The addition of at least one element of the iron group to an Sn-Ag-Cu lead-free solder is disclosed in U.S. Patent 6,179,935 and 6,231,691 and JP P11-216591A (1999). However, there is no disclosure therein regarding the production or use of solder balls for bump formation or the surface appearance of the solder. The ball form referred to in column 12 of U.S. Patent 6,179,935 is the shape of solder powder for use in a cream solder.

The Ag and Cu contents of the alloy composition in a lead-free solder ball according to the present invention are 3 - 6 at% and 1 - 3 at%, respectively.

When present in an amount of at least 3 at%, Ag serves to lower the melting point of the solder and improve the wettability and strength thereof. However, when the Ag content increases so as to exceed 6 at%, it adversely affects both the melting temperature and wettability of the solder. Preferably, the Ag content is in the range of 3 - 5 at%. In order to lower the melting point of the solder, it is also preferable that the Ag content be selected such that the atomic ratio of Ag to Sn is approximately 3 : 70.

When present in an amount of at least 1 at%, Cu serves to improve the strength of the solder. The presence of a small amount of Cu also provides the solder with improved wettability. However, like Ag, the presence of an excessive amount of Cu, which is greater than 4 at% for Cu, causes a rise in the melting temperature of the solder and deteriorates its wettability. Preferably, the Cu content is in the range of 1 - 3 at%. More preferably, the Cu content is selected such that the atomic ratio of Cu to Sn is approximately 1 : 70.

Although the addition of Co is effective for preventing the formation of dendrites during solidification and producing solder balls having a smooth surface with no shrinkage cavities or wrinkles, the addition can possibly adversely affect the wettability of the solder balls. In order to eliminate this possibility, phosphorus (P) is added in a small amount. Thus, the addition of P ensures that the solder can exhibit good wettability even though it contains Co. The content of P is in the range of 0.04 - 4 at%.

In a solder ball according to the present invention, Sn is the remainder of the solder composition. In general, the Sn content is in the range of 86 - 96 at%.

In addition, the solder composition may contain unavoidable impurities such as Pb, Sb, and Bi in a total amount of at most 0.2 at%.

There is no limitation on the diameter of a solder ball according to the present invention as long as the solder ball is suitable for use in the formation of solder bumps on a substrate for a BGA package or CSP. In general, the diameter is in the range of from 0.05 mm to 1.0 mm.

Solder balls according to the present invention can be produced by a method which comprises forming masses of molten solder of the above-described composition having almost equal volumes and solidifying the masses to form balls having almost equal diameters.

Examples of such a ball forming method include an oil bath method as disclosed in U.S. Patent No. 5,653,783 and JP P07-300606A (1995) and a direct method as disclosed in U.S. Patent No. 5,445,666, although other methods may be employed.

In the oil bath method, a wire of a solder having a predetermined composition is prepared and cut into portions having a given length. The wire portions are separately dropped into an oil bath having a vertical temperature gradient in which the temperature in an upper portion of the bath is higher than in a lower portion, whereby the portions are allowed to melt in the upper portion and then solidify while falling in the oil bath.

In the direct method, a molten solder having a predetermined composition is prepared. The molten solder is dripped or allowed to fall in droplets of a given size through an orifice or nozzle, and then solidified while falling in a chamber.

In both of these methods, the resulting solder balls have a spherical shape due to the action of the surface tension of the molten solder.

The following examples are presented to further illustrate the present invention. These examples are to be considered in all respects as illustrative and not restrictive.

### Examples

Solder balls having a diameter of 0.5 mm were produced from each of various solders having the compositions shown in Table 1 by a conventional oil bath method, and they were used to form solder bumps on a substrate for a BGA package by mounting the solder balls on the substrate using a solder ball feeder having holes for grasping solder balls by suction and then heating the substrate in a reflow furnace at a temperature sufficient to form solder bumps.

The reliability of mounting solder balls was evaluated by the percentage of solder balls with respect to which problems occurred during mounting of solder balls, i.e., the percentage of solder balls which were not grasped by the solder ball feeder by suction or which were not released from the feeder due to biting into the holes of the feeder.

In addition, the solder bumps formed on the substrate were checked by an optical inspection machine developed for checking solder bumps to determine the percent occurrence of misidentification of solder bumps in this inspection (the percentage of solder bumps which were not identified by the inspection machine).

The results obtained with each solder are also shown in Table 1 together with the surface appearance of the solder balls when observed under a scanning electron microscope (SEM) and the spreading factor determined in a conventional spreading test on a copper plate.

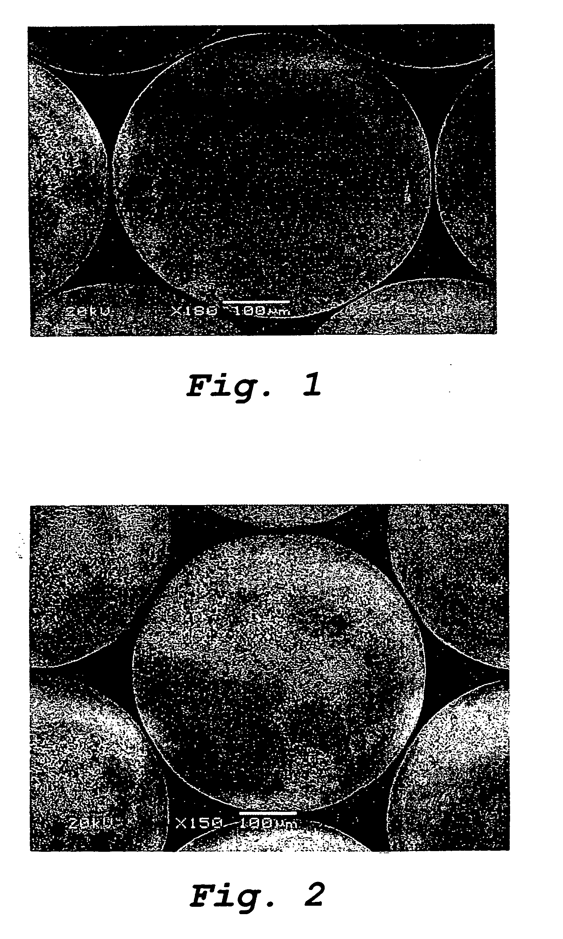

Electron photomicrographs of solder balls of Run No. 1, No. 6, and No. 7 in Table 1 are shown in Figures 1, 2, and 3, respectively.

**Table 1**

| Run No. | Solder composition (atomic %) | Ball surface | % Mounting problems | % Misidentification¹ | Spreading factor (%) | Remarks |
|---|---|---|---|---|---|---|
| 1 | Sn-3.8Ag-1.3Cu-0.02Co | smooth | 0.01 | 0.04 | 82 | * |
| 2 | Sn-3Ag-1.0Cu-0.02Co | smooth | 0.01 | 0.04 | 80 | * |
| 3 | Sn-5Ag-3.5Cu-0.02Co-3.4P | smooth | 0.01 | 0.04 | 78 | Invent.³ |
| 4 | Sn-3.8Ag-1.3Cu-0.2Co | smooth | 0.01 | 0.04 | 82 | * |
| 5 | Sn-3.8Ag-1.3Cu-1.0Co-3.4P | smooth | 0.03 | 0.06 | 82 | Invent. |
| 6 | Sn-3.8Ag-1.3Cu | irregular² | 0.08 | 1.2 | 82 | Compar.⁴ |
| 7 | Sn-25Pb | smooth | 0.01 | 0.03 | 92 | Compar. |

| | | | | | | |
|---|---|---|---|---|---|---|
| (Notes) ¹% Misidentification of solder bumps in optical inspection; ² Significant surface irregularities and shrinkage cavities were observed; ³ Example of this invention; ⁴ Comparative example. * Outside the invention | | | | | | |

As can be seen from Figure 2 and in Table 1, solder balls made of a conventional Sn-Cu-Ag lead-free solder in Run No. 6 showed significant surface irregularities and had shrinkage cavities on their surface when observed under a SEM, thereby resulting in significantly increased percentages of occurrence of mounting problems for solder balls and misidentification in optical inspection of solder bumps.

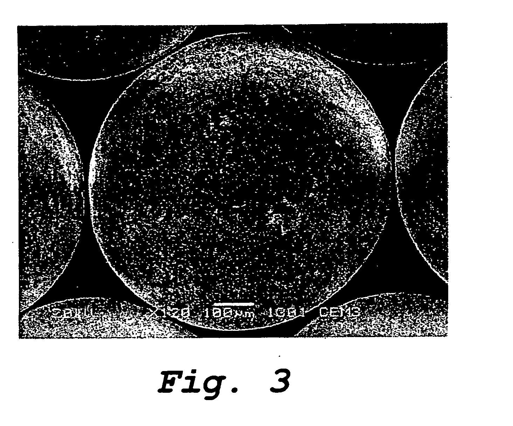

In contrast, as can be seen from Figure 1 which shows solder balls made of a lead-free solder of Run No. 1 in which 0.02 at% of Co was added to the solder of Run No. 6, surface irregularities were significantly suppressed and no shrinkage cavities were found on the surfaces of the solder balls, and the surfaces of the solder balls were as smooth as those of solder balls of a conventional Sn-Pb solder (Figure 3). The percentages of occurrence of mounting problems and misidentification in all the solder balls according to the present invention (Runs Nos. 3 and 5) were as low as those obtained with the conventional Sn-Pb solder in Run No. 7.

## Claims

1. A solder ball for forming a solder bump, said solder ball being made of a lead-free solder which comprises, by atomic percent, 3% - 6% of Ag, 1% - 4% of Cu, 0.01% - 2% of Co, 0.04% - 4% of P, and a balance of Sn, so as to prevents the formation of shrinkage cavities and wrinkles in the solder ball.

2. A method of forming solder bumps on a substrate comprising placing solder balls as claimed in claim 1 on the substrate followed by heating the substrate to melt the solder balls and form them into solder bumps secured to the substrate.

3. A substrate for a ball grid array package which have solder bumps formed from solder balls as claimed in claim 1.

## Patentansprüche

1. Lötkugel zur Bildung einer Lötperle, wobei die Lötkugel aus einem bleifreiem Lötmittel hergestellt ist, welches, in Atomprozent, 3 % - 6 % Ag, 1 % - 4 % Cu, 0,01 % - 2 % Co, 0,04 % - 4 % P und einen Rest aus Sn umfasst, um die Bildung von Schrumpfhohlräumen und Falten in der Lötkugel zu verhindern.

2. Verfahren zur Bildung von Lötperlen auf einem Substrat, umfassend das Anordnen von Lötkugeln, wie in Anspruch 1 beansprucht, auf dem Substrat, gefolgt vom Erwärmen des Substrats, um die Lötkugeln zu schmelzen und sie zu Lötperlen zu formen, die an dem Substrat befestigt sind.

3. Substrat für ein Kugelgitteranordnungspaket, das Lötperlen aufweist, die aus den Lötkugeln, wie in Anspruch 1 beansprucht, gebildet sind.

## Revendications

1. Bille de soudure pour la formation d'une perle de soudure, ladite bille de soudure étant constituée d'une soudure sans plomb qui comprend, en pourcentage atomique, 3 % à 6 % d'Ag, 1 % à 4 % de Cu, 0,01 à 2 % de Co, 0,04 % à 4 % de P, et un complément de Sn, de sorte à empêcher la formation de retassures et de plis dans la bille de soudure.

2. Procédé de formation de perles de soudure sur un substrat comprenant le placement des billes selon la revendication 1 sur le substrat suivi par le chauffage du substrat à l'état fondu des billes de soudure et la transformation de ces billes en perles de soudures sécurisées sur le substrat.

3. Substrat pour un emballage de boîtier à billes qui a des perles de soudure formées à partir de billes de soudure selon la revendication 1.
